# EUROPEAN PATENT APPLICATION

(11) **EP 1 728 891 A1**
(43) Date of publication of application: **06.12.2006**
(21) Application number: 05721588.1
(22) Date of filing: 22.03.2005
(51) Int. Cl.: C23C 14/14, C23C 14/34, H01L 21/203

(54) **SILICON FILM FORMING EQUIPMENT**

(30) Priority: 26.03.2004 JP 2004091888
(71) Applicant: Nissin Electric Co., Ltd., Kyoto-shi, Kyoto 615-8686 (JP)
(72) Inventor: TOMYO, Atsushi, c/o Nissin Electric Co., Ltd., Kyoto-shi, Kyoto 615-8686 (JP); TAKAHASHI, Eiji, c/o Nissin Electric Co., Ltd., Kyoto-shi, Kyoto 615-8686 (JP); FUJIWARA, Masaki, c/o Nissin Electric Co., Ltd., Kyoto-shi, Kyoto 615-8686 (JP); KOTERA, Takashi, c/o Nissin Electric Co., Ltd., Kyoto-shi, Kyoto 615-8686 (JP); ONODA, Masatoshi, c/o Nissin Electric Co., Ltd., Kyoto-shi, Kyoto 615-8686 (JP)
(74) Representative: Barz, Peter
(86) International application number: PCT/JP2005/005661
(87) International publication number: WO 2005/093119

(57) **Abstract**

A silicon film forming apparatus includes a deposition chamber (10), a silicon sputter target (2) arranged in the chamber, a hydrogen gas supply circuit (102 or 102') supplying a hydrogen gas into the chamber, and a high-frequency power applying device (antenna 1, 1', power source PW and others) generating inductively coupled plasma by applying high-frequency power to the gas supplied into the deposition chamber (10). Chemical sputtering is effected on the target (2) by the plasma to form a silicon film on a substrate S. A silane gas may be used. A silane gas supply circuit (101) may be provided with a gas reservoir unit (GR). The silicon film can be formed inexpensively and fast at a relatively low temperature.

## Description

### TECHNICAL FIELD

The present invention relates to an apparatus for forming a silicon film.

### BACKGROUND ART

Silicon thin films have been used, e.g., as materials of TFT (thin film transistor) switches arranged at pixels of liquid crystal displays as well as materials of various integrated circuits, solar cells and others. It has been expected to use them in nonvolatile memories, light emitting elements and optical sensitizer.

Various methods have been known for forming the silicon films. For example, a method of forming an amorphous silicon thin film at a relatively low temperature by a method among various CVD and PVD methods has been known, and also such a method has been known that a heat treatment at about 1000 deg. C (°C) or a long-time heat treatment at about 600 deg. C is effected as a post-treatment on the amorphous silicon thin film formed in the above method. Further, such methods have been known that a deposition target substrate is kept at a temperature between 600 deg. C and 800 deg. C or higher, and a CVD method such as a plasma CVD method or a PVD method such as a sputtering vapor deposition method is effected at a lower pressure to form a crystalline silicon thin film, and that laser annealing is effected on an amorphous silicon film to crystallize the film.

In addition to the above, such a method has been proposed that a plasma of a gas prepared by diluting a silane-containing gas such as monosilane (SiH₄) or disilane (Si₂H₆) with hydrogen or silicon fluoride (SiF) is prepared and, in this plasma, an amorphous silicon film or a crystalline silicon thin film is directly formed on a substrate at a low temperature of about 500 deg. C or lower [see, e.g., Japanese Laid-Open Patent Publication S63-7373 (JP63-7373A)].

However, these methods do not necessarily satisfy the film deposition rate and particularly the film deposition rate in an initial stage of the film deposition.

In the method of forming the film in the plasma of the gas which is prepared by diluting the silane-containing gas with hydrogen or silicon fluoride (SiF) as disclosed in the Japanese Laid-Open Patent Publication No. S63-7373 (JP63-7373A), the silicon thin film can be formed at a relatively low temperature. However, the silane-containing gas is used by diluting it with a hydrogen gas or the like so that the film deposition rate is low.

In the method of exposing the deposition target substrate to a high temperature, it is necessary to employ, as a substrate for film deposition, a substrate (e.g., silica glass substrate) which is resistant to a high temperature and thus is expensive, and it is difficult to form the silicon thin film on an inexpensive glass substrate having a low melting point and thus having a heat-resisting temperature not exceeding 500 deg. C. Therefore, the cost of the substrate increases the producing cost of the silicon thin films. A similar problem occurs when a heat treatment at a high temperature is effected on the amorphous silicon films.

In the case where the laser annealing is effected on the amorphous silicon film, a crystalline film can be obtained with a relatively low temperature. In this case, however, a laser irradiation step is required, and laser beams of an extremely high energy density must be emitted. For these and other reasons, the producing cost of the crystalline silicon thin film in this case is likewise high. Various portions of the film cannot be uniformly irradiated with the laser beams without difficulty, and further the laser irradiation may cause hydrogen desorption and thus may roughen the surface of the film so that it is difficult to obtain the crystalline silicon thin film of good quality.

Accordingly, an object of the invention is to provide a silicon film forming apparatus which can inexpensively form a desired silicon film at a relatively low temperature, can smoothly start the film formation and thereby can improve a film deposition rate to form the desired silicon film.

Another object of the invention is to provide a silicon film forming apparatus which can inexpensively form a desired silicon film at a relatively low temperature, and can smoothly start the film formation and can improve the film deposition rate for a period from the start of the film formation to the end thereof to form the desired silicon film.

Still another object of the invention is to provide a silicon film forming apparatus which has the above advantages, and allows movement, positioning and others of a deposition target object in a deposition chamber in a smooth and accurate manner and thereby can smoothly form a silicon film.

### DISCLOSURE OF THE INVENTION

The invention provides a silicon film forming apparatus including a deposition chamber accommodating a deposition target object; a silicon sputter target arranged in the deposition chamber; a gas supply device having a hydrogen gas supply circuit supplying a hydrogen gas into the deposition chamber; and a high-frequency power applying device applying a high-frequency power to the hydrogen gas supplied from the hydrogen gas supply circuit into the deposition chamber, and thereby generating inductively coupled plasma, wherein a silicon film is formed on the deposition target object arranged in the deposition chamber by effecting chemical sputtering on the silicon sputter target by the plasma.

According to this silicon film forming apparatus, the deposition target object is arranged in the deposition chamber, the hydrogen gas supply circuit of the gas supply device supplies the hydrogen gas into the deposition chamber, and the high-frequency power applying device applies the high-frequency power to the gas to generate the inductively coupled plasma, thereby the deposition chamber is enriched with hydrogen radicals and hydrogen ions, and chemical sputtering (reactive sputtering) is performed on the silicon sputter target with the plasma to form a silicon film on the deposition target object.

Further, the film formation can be performed at a relatively low temperature, and the silicon film can be formed over an inexpensive glass substrate having a low-melting point and a heat-resistant temperature, e.g., of 500 deg. C or lower. This allows inexpensive formation of the silicon film.

At the start of the film formation, the chemical sputtering performed on the silicon sputter target by the inductively coupled plasma smoothly forms nucleuses or seeds for growing the silicon film on the deposition target object. The formation of the nucleuses or seeds smoothly starts the silicon film formation, and will continue the smooth formation of the silicon film. Accordingly, at least the film formation can be smooth, and this can increase the deposition or formation rate of the silicon film.

The inventors observed that Hα (656 nm) and Hβ (486 nm) become dominant in the plasma when producing the plasma of the hydrogen gas in the inductive coupling method and performing spectroscopic analysis of emission of light derived from the plasma. Hα (656 nm) represents an emission spectral intensity of the hydrogen exhibiting a peak at a wavelength of 656 nm by spectroscopic analysis of emission of light derived from the plasma. Hβ (486 nm) represents an emission spectral intensity of the hydrogen exhibiting a peak at a wavelength of 486 nm. The richness of Hα and Hβ means a state that is rich with the hydrogen radicals.

The plasma potential of the hydrogen gas plasma formed in the inductive coupling method is, e.g., about 20 eV and is very low in any case, although it depends on conditions. Therefore, a usual physical sputtering is unlikely to occur. However, the inventors observed the presence of Si (288 nm) by spectroscopic analysis of emission of light from the plasma. This is caused by chemical sputtering (reactive sputtering) by the hydrogen radicals and hydrogen ions at the surface of the silicon sputter target.

This silicon film forming apparatus can form a crystalline silicon film by controlling the quantity of the supplied hydrogen gas, the high-frequency power (particularly, the frequency and/or the magnitude thereof), the deposition gas pressure in the deposition chamber and others.

For example, the gas plasma of Hα/SiH* from 0.3 to 1.3 is generated from the hydrogen gas by the above control. With this plasma, chemical sputtering is effected on the silicon sputter target, and a film is deposited on the deposition target object by an excitation effect of hydrogen gas plasma and sputtered atoms as well as a reaction of hydrogen radicals with a surface of the deposited film on the deposition target object and the like. This method forms a crystalline silicon film of good quality exhibiting crystallinity, having a small surface roughness and having a surface where hydrogen-terminated silicon' dangling bonds exist, similarly to a conventional crystalline silicon film formed in plasma of a gas prepared by diluting a silane-containing gas with a hydrogen gas.

The above SiH* represents an emission spectral intensity (wavelength of 414 nm) of silane radicals which are generated by the sputtering of the silicon sputter target with the hydrogen gas plasma generated by applying the high-frequency power to the hydrogen gas supplied into the deposition chamber, and are present in the gas plasma.

The Hα represents an emission spectral intensity of the hydrogen in the Balmer series exhibiting a peak at a wavelength of 656 nm by spectroscopic analysis of emission of light derived from the plasma.

Hα/SiH* represents richness of the hydrogen radicals in the plasma. When this value is lower than 0.3, the crystallinity of the deposited film lowers. When it exceeds 1.3, it conversely makes the film deposition difficult. The value of Hα/SiH* can be obtained based on a result of measurement performed by measuring the emission spectrums of various radicals with an optical emission spectroscopic analyzer for plasma. Control of Hα/SiH* can be typically performed by controlling a magnitude of the high-frequency power applied to the introduced gas and a deposition gas pressure.

A high-frequency antenna for application of the high-frequency power may be arranged outside the deposition chamber, or may be arranged inside the deposition chamber for efficient power application. When it is arranged outside the deposition chamber, a wall portion of the deposition chamber opposed to the high-frequency antenna may be made of a dielectric material.

When it is arranged inside the deposition chamber, it is preferable to coat a surface of a conductive portion of the antenna with an electrically insulating material (e.g., alumina). By coating the antenna with the electrically insulating material, such a situation can be suppressed that the antenna is sputtered with charged particles coming from the plasma due to a self-bias, and the sputter particles coming from the antenna are mixed into the film which is being deposited.

A form of the antenna is not particularly restricted. For example, it may be selected from various forms such as rod-like, ladder-like, U-shaped, ring-like, half-ring-like, coil-like and spiral forms.

The silicon sputter target can be provided in various states. For example, a whole or a part of a portion of the deposition chamber to be in contact with the gas plasma (e.g., an inner wall of the deposition chamber which is likely to be in contact with the plasma) is coated with silicon by silicon film formation, adhesion of silicon wafer, attachment of a silicon piece or the like to provide the silicon sputter target. The silicon sputter target independent of the deposition chamber itself may be arranged inside the deposition chamber.

In either of the cases where the high-frequency antenna is arranged outside the deposition chamber, and where it is arranged inside the deposition chamber, it is preferable for smooth chemical sputtering that the silicon sputter target is located in a position opposed to at least the high-frequency antenna which is a plasma generation region, and in other words, in a position near the high-frequency antenna.

For example, when the high-frequency antenna is located inside the deposition chamber, the silicon sputter target opposed to the high-frequency antenna may be a silicon sputter target of a cylindrical form which surrounds the antenna and is opened toward the deposition target object.

In any one of the above cases, the potential of the plasma for forming the crystalline silicon film is preferably and substantially in a range from 15 eV to 45 eV, and an electron density is preferably and substantially in a range from 10¹⁰ cm⁻³ to 10¹² cm⁻³.

The deposition chamber pressure for forming the crystalline silicon film is preferably and substantially in a range from 0.6 Pa to 13.4 Pa (from about 5 mTorr to about 100 mTorr).

When the plasma potential for forming the crystalline silicon film is lower than 15 eV, the crystallinity lowers. When it is higher than 45 eV, the crystallization is impaired.

When the electron density in the plasma is smaller than 10¹⁰ cm⁻³, the crystallinity lowers, and/or the deposition rate lowers. When it is larger than 10¹² cm⁻³, the film and the substrate are liable to be damaged. When the deposition chamber pressure for forming the crystalline silicon film is lower than 0.6 Pa (about 5 mTorr), the plasma becomes unstable, and/or the deposition rate lowers. When it is higher than 13.4 Pa (about 100 mTorr), the plasma becomes unstable, and/or the crystallinity of the film lowers.

The plasma potential and the electron density of the plasma can be controlled by adjusting at least one of the magnitude of the applied high-frequency power, frequency of the power, deposition pressure and others.

The high-frequency antenna will be described further in detail. In a desirable example of the high-frequency antenna arranged in the deposition chamber, the antenna extends from the outside of the deposition chamber into the deposition chamber, and has a portion which is located in the deposition chamber and is divided electrically in parallel, and each of the divided portions has an end directly connected to the deposition chamber. In this case, the deposition chamber potential can be set to the ground potential.

Since the portion of this antenna outside the deposition chamber does not contribute to the plasma production, the length of this portion can be minimized, and can be directly connected to a matching box in the high-frequency power applying device, and the antenna end is directly connected to the deposition chamber without leading it to the outside of the deposition chamber. Therefore, the whole antenna length can be short. Further, the parallel interconnection structure having electrically parallel divided portions inside the deposition chamber can reduce the inductance of the antenna.

Thereby, disadvantages such as abnormal discharging and matching failure can be suppressed more effectively than a conventional high-frequency antenna, and desired plasma can be generated while suppressing the disadvantages such as abnormal discharging and matching failure even when the frequency of the high-frequency power to be applied is raised for improving the plasma characteristics.

For reducing the required space in the deposition chamber, it is preferable that the high-frequency antenna has a compact structure and achieves high utilization efficiency of the high-frequency power. In view of this, the high-frequency antenna may have a three-dimensional structure. In a typical example, the high-frequency antenna may have a first portion extending from the outside of the deposition chamber through a wall of the deposition chamber into the deposition chamber, and a plurality of second portions diverging radially from an end of the first portion inside the deposition chamber, and extending toward the deposition chamber wall, and the end of each of the second portions is directly connected to the deposition chamber wall.

Even when the high-frequency antenna is arranged, e.g., near an inner wall of a plasma generating chamber, it can apply an induction field to regions around the first and second portions of the antenna more effectively than an antenna of a planar structure arranged parallel to the chamber wall, and thereby it can apply the electric field effectively to a wide range in the deposition chamber so that the high-frequency power can be utilized effectively.

For example, a group of the second portions of the antenna may have a U-shaped form, a vertically opening quadrilateral-shaped form or semicircular form or the like as a whole, or antenna portions each having the above form may be combined, e.g., to cross each other at the first portion with a predetermined angular space therebetween.

In any one of the above structures, the high-frequency power applied to the high-frequency antenna may have a frequency of 13.56 MHz of a commercial power. However, the high-frequency antenna of the foregoing type is for the low inductance as described above, and therefore the frequency may be substantially in a range from 40 MHz to 100 MHz or in a higher range of several hundreds of megahertz, and may be equal to, e.g., about 60 megahertz. Even the high-frequency power of such a high frequency can be used as described above, and thereby the plasma characteristics can be improved in connection with the plasma density and others.

The gas supply device may include a silane gas supply circuit. Owing to provision of the silane gas supply circuit, this circuit can supply a silane gas into the deposition chamber for forming a silicon film so that the silicon film can be formed at a high deposition rate.

The silane gas supply circuit may be configured to supply the silane gas into the deposition chamber simultaneously with the supply of the hydrogen gas from the hydrogen gas supply circuit into the deposition chamber, or may be configured to supply the silane gas into the deposition chamber after the start of the chemical sputtering of the silicon sputter target by the hydrogen gas plasma, i.e., in a state where the chemical sputtering of the target by the hydrogen gas plasma formed nucleuses or seeds of the silicon film.

In any one of the above cases, the supply of the silane gas can increase the rate of the silicon film formation.

In either of the case where the silane gas and the hydrogen gas are supplied simultaneously and the case where the silane gas is supplied after the start of the chemical sputtering of the target, the silane gas supply circuit may include a gas reservoir unit which stores the silane gas prior to the start of the silane gas supply, and will suddenly supply the stored silane gas into the deposition chamber in the operation of supplying the silane gas into the deposition chamber, and also may include a silane gas supply unit including a flow rate control unit which starts the supply of the silane gas into the deposition chamber at a controlled flow rate simultaneously with the supply of the silane gas from the gas reservoir unit, and thereafter continues the supply of the silane gas into the deposition chamber at a controlled flow rate.

By employing the silane gas supply circuit having the gas reservoir unit, the gas suddenly supplied from the gas reservoir unit can suddenly spread in the deposition chamber, and thereby the effect of the silane gas supply can be reliably achieved even at the start of the silane gas supply so that the faster film deposition can be achieved.

The silicon film forming apparatus according to the invention may include a transporting member arranged in the deposition chamber for moving the deposition target object between a first position for silicon film formation and a second position different from the first position, and an elevator mechanism for vertically moving the transporting member. Further, it may include a counter balance mechanism.

The object transporting member may be configured to move vertically with respect to an object holder for holding the deposition target object in the first position, and may serve also as the object holder. In the latter case, the elevator mechanism vertically moves the object holder.

A typical example of the elevator mechanism may include:
a transporting member support member for supporting the transporting member, and vertically movably extending through the deposition chamber wall;
a bellows supporting member arranged at an end of a portion of the transporting member supporting member located outside the deposition chamber;
an extensible bellows having one end air-tightly connected to the deposition chamber and the other end air-tightly connected to the bellows supporting member, and air-tightly surrounding a portion of the transporting member supporting member located outside the deposition chamber; and
a drive unit vertically driving the transporting member supporting member.

A typical example of the counter balance mechanism in the structure employing the above elevator mechanism may be configured at least to generate opposite forces canceling a first load applied to the drive unit when the inner pressure of the deposition chamber is the same as the inner pressure at the time of setting a depressurized atmosphere for the silicon film formation, and a second load applied to the drive unit when the inner pressure of the deposition chamber is a predetermined high pressure higher than the inner pressure at the time of setting the depressurized atmosphere, respectively.

When employing the transporting member, the elevator mechanism and the counter balance mechanism, the transporting member driven by the elevator mechanism can locate the deposition target object transported into the deposition chamber to the first position for the deposition processing.

By moving the transporting member by the elevator mechanism, the object subjected to the deposition processing can be moved to the second position different from the first position, e.g., to a position where transportation of the deposition target object into and from the deposition chamber is performed so that next processing (e.g., discharge of the film-deposited object or take-in of a new deposition target object) can be performed.

The counter balance mechanism generates at least the opposite forces canceling the first load applied to the drive unit of the elevator mechanism when the inner pressure of the deposition chamber is the same as the inner pressure at the time of setting the depressurized atmosphere for the film formation, and the second load applied to the drive unit when the inner pressure of the deposition chamber is the predetermined high pressure higher than the inner pressure at the time of setting the depressurized atmosphere, respectively.

The first load is based on a force (= f - WF) acting to contract the bellows and obtained by subtracting the member gravity WF acting downward on the transporting member based on the transporting member, the support member of the transporting member, the bellows supporting member, an object supported by the transporting member and others from the force f which acts on a portion of the bellows supporting member, and is caused corresponding to a diameter (sectional area) of the extensible bellows by the difference in gas pressure between the outside and the inside of the deposition chamber as a result of the setting of the depressurized atmosphere (pressure lower than the outside atmospheric pressure) in the deposition chamber.

The second load is a load which is present when the inner pressure of the deposition chamber is the predetermined high pressure higher than the inner pressure at the time of setting the above depressurized atmosphere, and typically when it is equal to the atmospheric pressure (including the exact atmospheric pressure and the pressure close to it), and is primarily based on the member gravity WF.

The above load canceling effect of the counter balance mechanism remarkably suppresses the load applied to the drive unit of the elevator mechanism, and therefore the drive unit can have a small capacity in vertical power for driving the transporting member, toughness of the structure and others and can be inexpensive, and thus the film forming apparatus can be inexpensive.

Owing to the load canceling effect of the counter balance mechanism, the drive unit can readily move the transporting member, and the transporting member can readily stop according to the stop of driving of the drive unit. Further, a shock caused at the time of stopping can be small so that the transporting member can accurately stop at the first and second positions. Also, it is possible to suppress deviation in position and damages of the deposition target object on the transporting member.

Even when the drive unit does not include a brake function, the transporting member can stop accurately at the predetermined position without a large shock owing to the load canceling effect of the counter balance mechanism, and it is possible to employ a linear stepping mechanism (drive mechanism linearly driving a drive target in a position-controllable manner by a stepping motor) or the like not having a brake function.

For example, the counter balance mechanism can have the following structure.

The counter balance mechanism includes a piston cylinder device having a piston rod coupled to the support member of the transporting member, and a working fluid circuit supplying a working fluid to the piston cylinder device to cancel the first load in an operation of canceling the first load, and supplying the working fluid to the piston cylinder device to cancel the second load in an operation of canceling the second load.

Preferably, the working fluid circuit can maintain the piston cylinder device in a state attained before a power failure during the power failure. For example, the working fluid circuit may include an electromagnetic on-off valve switching a working fluid passage. The electromagnetic on-off valve in the off state maintains the same valve position as that attained immediately before the power-off so that the piston cylinder device can be kept in the same state as that attained immediately before the power failure.

By employing the working fluid circuit described above, even when the drive unit stops the driving due to the power failure or the like, it is possible to prevent falling of the object transporting member due to the member gravity and jumping due to the pressure difference acting on the bellows support member, and thus it is possible to suppress the position deviation and damages of the target object held by the object transporting member.

The drive unit of the elevator mechanism may include, e.g., a rotary motor and a power transmission mechanism converting a rotary motion of the motor to a linear motion and transmitting it to the transporting member support member. In this case, it is possible to employ, as the rotary motor, a servo motor with a brake exhibiting a braking force when the power failure occurs.

According to the invention, as described above, it is possible to provide the silicon film forming apparatus which can inexpensively form the desired silicon film at a relatively low temperature, can smoothly start the film formation and thereby can improve a deposition rate for forming the desired silicon film.

Also, the invention can provide the silicon film forming apparatus which can inexpensively form the desired silicon film at a relatively low temperature, and can smoothly start the film formation and can improve the deposition rate for a period from the start of the film formation to the end thereof for forming the desired silicon film.

Further, the invention can provide the silicon film forming apparatus having the above advantages, and further can smoothly and accurately perform the movement, positioning and others of the deposition target object in the deposition chamber so that the silicon film formation can be performed smoothly.

### BRIEF DESCRIPTION OF THE DRAWINGS

Fig. 1 shows a schematic structure of an example of a silicon film forming apparatus according to the invention.
Fig. 2 illustrates a result of evaluation effected on crystallinity of a silicon film formed by the silicon film forming apparatus shown in Fig. 1 by a laser Raman spectral analysis.
Fig. 3 shows a schematic structure of another example of the silicon film forming apparatus according to the invention with an object holder located in a raised position.
Fig. 4 shows the film forming apparatus shown in Fig. 3 with the object holder located in the lowered position.
Fig. 5 is a block diagram schematically showing a control circuit of the film forming apparatus shown in Fig. 3.
Fig. 6 is a flowchart schematically showing an example of an operation of the control unit shown in Fig. 5.
Fig. 7 shows another example of a high-frequency antenna together with a part of the film forming apparatus.
Fig. 8 shows an example of a three-dimensional structure of the antenna shown in Fig. 7.

### PREFERRED EMBODIMENTS FOR IMPLEMENTING THE INVENTION

Embodiments of the invention will now be described with reference to the drawings.

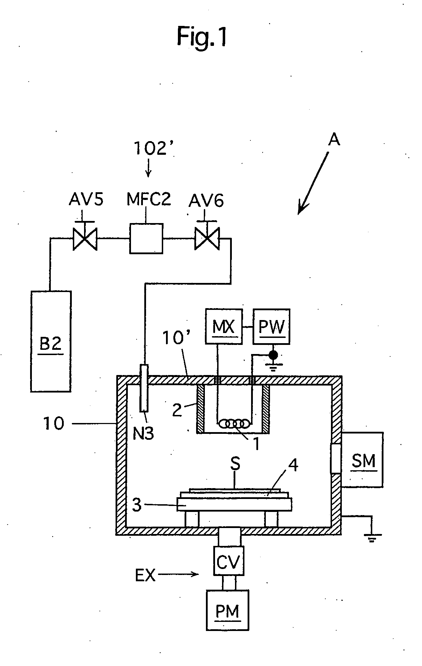

### (1) Silicon film forming apparatus A shown in Fig. 1

Fig. 1 shows a schematic structure of an example of a silicon film forming apparatus according to the invention.

A film forming apparatus A shown in Fig. 1 includes a deposition chamber 10, and a work or object holder 3, a high-frequency antenna 1 located above the holder and a silicon sputter target 2 opposed to the antenna are arranged in the deposition chamber.

A conductive surface of the antenna 1 is coated with an insulating film made of alumina and having a thickness equal to or slightly larger than 100 nm.

The antenna 1 is connected to a high-frequency power source PW via a matching box MX. The power source PW is an output variable power source, and can supply a high-frequency power of a frequency of 13.56 MHz in this film forming apparatus. The power source frequency is not restricted to 13.56 MHz, and may be selected from a range, e.g., from about 40 megaheltz to 100 megahertz or several hundreds of megaheltz. The antenna 1, matching box MX and high-frequency power source PW form a high-frequency power applying device.

The object holder 3 is provide with a heater 4 for heating a deposition target object or work (a substrate S in this example). The object holder 3 is grounded together with the deposition chamber 10.

The silicon sputter target 2 has a cylindrical form surrounding and opposed to the antenna 1, and is attached to a top wall 10' of the deposition chamber 10. The lower end of the cylindrical target 2 is opened toward the holder 3. In addition to the target 2, a silicon sputter target may be arranged on, e.g., a top wall portion of the deposition chamber surrounded by the target 2. Such a target can be arranged, e.g., by holding a silicon wafer on the top wall portion by adhesion or the like. As described above, the silicon sputter target is arranged in a position where it can be readily in contact with a plasma formed in the deposition chamber 10.

A gas inlet nozzle N3 is arranged at the top wall 10' of the deposition chamber 10, and particularly in a region outside the target 2, and is connected to a hydrogen gas container B2 via an electromagnetic on-off valve AV6, a massflow controller MFC2 and an electromagnetic on-off valve AV5. These form a hydrogen gas supply device 102' including a flow rate control unit (the massflow controller in this example) supplying the hydrogen gas to the deposition chamber 10 at a controlled flow rate.

In addition to the above, an exhaust device EX for exhausting a gas from the deposition chamber 10 is connected to the deposition chamber 10, and an optical emission spectroscopic analyzer SM for plasma is also employed for measuring a state of the plasma formed in the deposition chamber. The exhaust device EX is formed of a conductance valve CV controlling an exhaust flow rate and a vacuum pump PM connected to the deposition chamber 10 via the valve.

According to this silicon film forming apparatus A, the deposition target substrate S is arranged on the object holder 3 in the deposition chamber 10, and the hydrogen gas supply circuit 102' supplies the hydrogen gas into the deposition chamber. The power source PW applies the high-frequency power to this gas via the matching box MX to generate inductively coupled plasma, and thereby attains a state in which the deposition chamber 10 is rich in hydrogen radicals and hydrogen ions. Thereby, the plasma effects chemical sputtering (reactive sputtering) on the silicon sputter target 2 to form a silicon film on the substrate S.

Further, the silicon film can be formed at a relatively low temperature, and the silicon film can be formed on an inexpensive glass substrate having a low-melting point and a heat-resistant temperature, e.g., of 500 deg. C or lower, which allows inexpensive formation of the silicon film.

At the start of the film formation, the chemical sputtering performed on the silicon sputter target 2 by the inductively coupled plasma smoothly forms nucleuses or seeds for growing the silicon film on the substrate S. These smoothly start the silicon film formation, and the smooth formation of the silicon film will continue. At least the film formation is smooth, and this can increase the deposition or formation rate of the silicon film.

In the silicon film formation, an amorphous silicon film or a crystalline silicon film can be formed by controlling one or more of the quantity of the hydrogen gas supplied into the deposition chamber 10, the high-frequency power (particularly, the frequency and the magnitude of the power) to be applied, the deposition gas pressure in the chamber 10 and others.

Examples of forming the crystalline silicon film on the substrate S will now be described.
For forming the crystalline silicon film, the deposition gas pressure in the deposition chamber is kept in a range from 0.6 Pa to 13.4 Pa (about 5 mTorr - about 100 mTorr).

Prior to the film deposition, the pump PM starts to exhaust the gas from the deposition chamber 10 via the conductance valve CV. The exhaust quantity of the conductance valve CV is adjusted in view of the deposition gas pressure of 0.6 Pa - 13.4 Pa in the deposition chamber 10.

When the pump PM lowers the inner pressure of the deposition chamber 10 below an intended deposition gas pressure, the valves AV5 and AV6 of the gas supply circuit 102' open to supply the hydrogen gas into the deposition chamber 10 at a flow rate controlled by the massflow controller MFC2, and the power source PW applies the high-frequency power to the high-frequency antenna 1 so that plasma is produced from the supplied hydrogen gas in an inductive coupling manner.

From the information obtained by the optical emission spectroscopic analyzer SM from the plasma thus produced, Hα (656 nm) and Hβ (486 nm) in the plasma are obtained. By controlling at least one of the high-frequency power applied to the antenna 1, the quantity of the hydrogen gas supplied into the deposition chamber 10 and controlled by the massflow controller MFC2, the deposition gas pressure (the amount of gas exhausted by the exhaust device EX) and others, the conditions such as the high-frequency power, the quantity of the supplied hydrogen gas and the deposition gas pressure are determined such that the emission intensity at Hα (656 nm) and Hβ (486 nm) in the hydrogen gas plasma may be sufficiently large.

The conditions such as the high-frequency power and the quantity of the supplied hydrogen gas are determined such that Hα/SiH* in the plasma falls within a range from 0.3 to 1.3, the potential of the plasma falls within a range from 15 eV to 45 eV and the electron density in the plasma falls within a range from 10¹⁰ cm⁻³ to 10¹² cm⁻³.

The plasma potential and the electron density in the plasma can be checked, e.g., in the Langmuir probe method.

In view of the above, the conditions such as the high-frequency power, quantity of the supplied hydrogen gas and the deposition gas pressure are finally determined.

After determining the deposition conditions, the film formation is performed according to the determined conditions.

For the film formation, the heater 4 is set to heat the deposition target substrate S held by the holder 3 to a relatively low temperature not exceeding 500 deg. C and, e.g., to about 400 deg. C, and the deposition target substrate S is placed on the holder 3. The pump PM exhausts the gas from the deposition chamber 10, and subsequently the hydrogen gas supply circuit 102' supplies a predetermined amount of the hydrogen gas into the deposition chamber 10. Also, the power source PW applies the high-frequency power to the antenna 1. Thereby, the antenna 1 performs the discharging in the inductive coupling manner to generate the plasma.

Thereby, the plasma effects the chemical sputtering on the silicon sputter target 2 opposed to the antenna 1, and thereby the silicon thin film is formed on the substrate S, Similarly to a crystalline silicon film formed in conventional plasma which is generated from a gas obtained by diluting a silane-containing gas with a hydrogen gas, this film is the silicon film exhibiting the crystallinity, and has a surface where hydrogen-terminated silicon's dangling bonds exist.

An example of an experiment of forming a crystalline silicon film by the silicon film forming apparatus A shown in Fig. 1 will now be described.

The conditions and others are as follows:
Substrate: non-alkali glass substrate
Substrate temperature: 400 deg. C.(400°C)
High-frequency power source: 13.56 MHz, 2000 W
Hydrogen gas supply quantity: 50 sccm
Deposition pressure: 13 Pa (98 mTorr)
Hα/SiH* in plasma: 1.0
Plasma potential: 30 eV
Electron density in plasma: 10¹¹ cm⁻³
Film thickness: about 500 Å

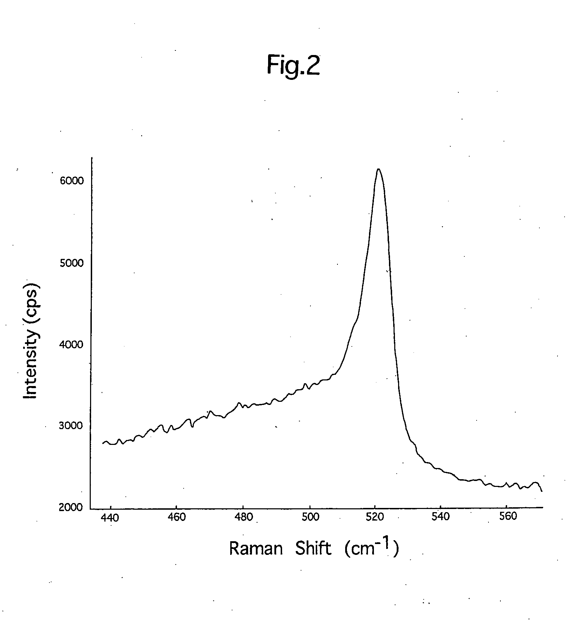

A crystallinity of the film obtained in this example was evaluated by laser Raman spectral analysis. According to the result, a peak exhibiting the crystallinity of Raman-shift 520 cm⁻¹ was present as illustrated in Raman spectrums of Fig. 2, and the crystallinity was confirmed.

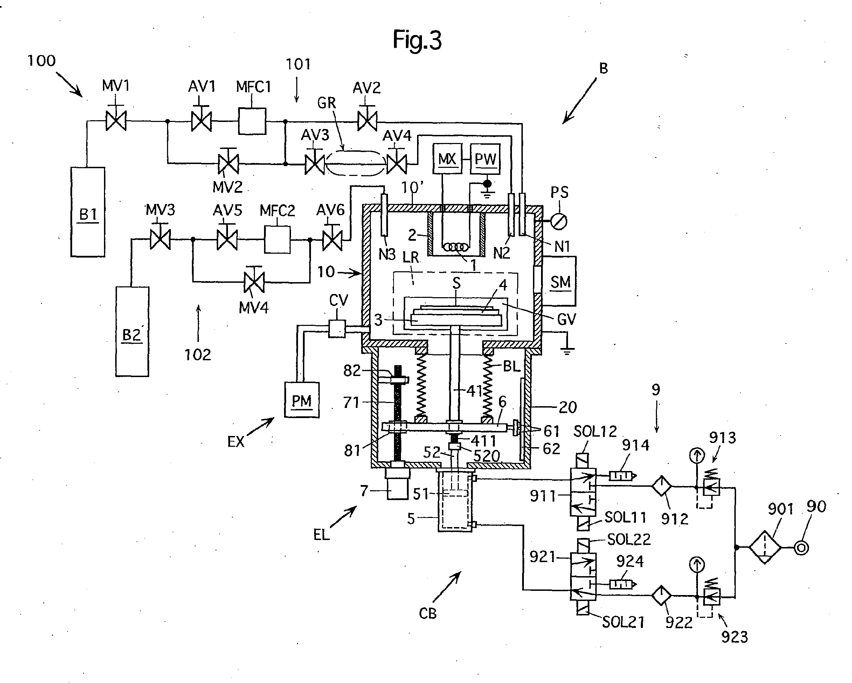

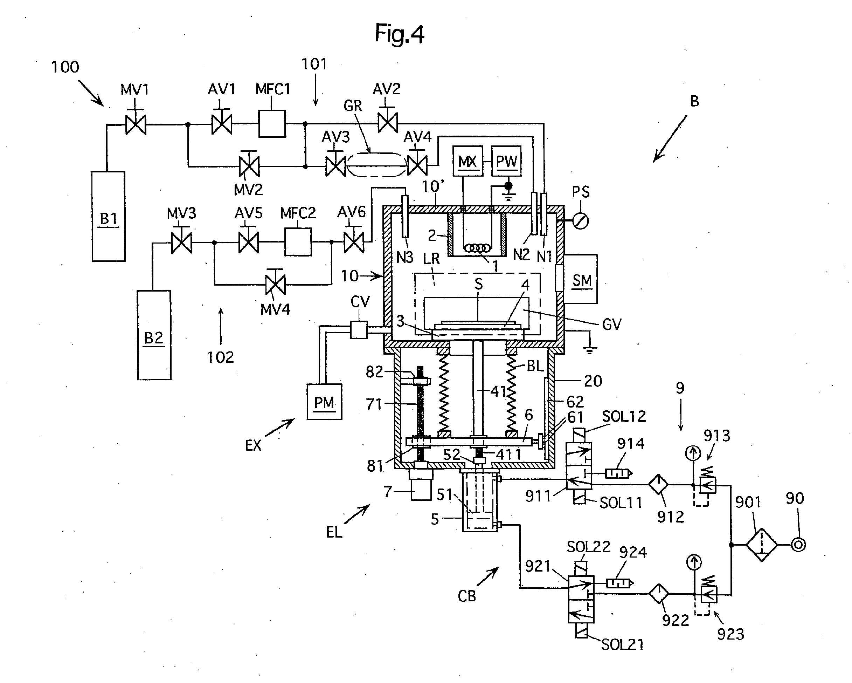

### (2) Silicon film forming apparatus shown in Figs. 3 and 4

Another example B of the silicon film forming apparatus will now be described. Figs. 3 and 4 show a schematic structure of the apparatus B. Fig. 3 shows a state in which the atmospheric pressure is kept in the deposition chamber and the object holder 3 is located in a raised position. Fig. 4 shows a state in which the deposition pressure is kept in the deposition chamber, and the object holder 3 is in the lowered position.

Similarly to the apparatus A shown in Fig. 1, the film forming apparatus B includes the deposition chamber 10, the high-frequency antenna 1 arranged in the deposition chamber, the silicon sputter target 2, the object holder 3, the high-frequency power applying device (high-frequency power source PW and the matching box MX) applying the high-frequency power to the antenna 1, a hydrogen gas supply circuit 102, the exhaust device EX, the optical emission spectroscopic analyzer SM for plasma and others.

This apparatus B perform the film formation by effecting the chemical sputtering on the silicon sputter target 2 by the plasma and the film formation by the plasma of monosilane (SiH₄) and hydrogen gas (H₂), and thereby can perform the fast film formation.

The object holder 3 is provided with the substrate heater 4, and is grounded together with the deposition chamber 10. A gas supply device 100 is arranged for the deposition chamber 10.

The gas supply device 100 includes a circuit 101 supplying the silane gas (SiH₄) into the deposition chamber 10 and the above-mentioned circuit 102 supplying the hydrogen gas thereinto.

The circuit 101 has a silane container B1 as well as valves MV1 and AV1, a massflow controller MFC1, a valve AV2 and a nozzle N1 successively connected to the silane container B1. Valves MV2, AV3 and AV4 and a nozzle N2 are successively connected between the valves MV1 and AV1 via pipes. The pipe between the controller MFC1 and the valve AV2 and the pipe between the valves MV2 and AV3 are connected together for communication.

All of these valves are electromagnetic on-off valves which open when energized, and close when deenergized. The massflow controller MFC1 can pass the gas at the predetermined flow rate set therein when it is energized. The nozzles N1 and N2 are arranged at the top wall 10' of the deposition chamber 10, and open into the deposition chamber.

The valves AV3 and AV4 and a pipe therebetween form a gas reservoir unit GR.

The hydrogen gas supply circuit 102 in the silicon film forming apparatus B has the hydrogen gas container B2 as well as valves MV3 and AV5, a massflow controller MFC2, a valve AV6 and a nozzle N3 connected successively to the container B2. A valve MV4 is arranged in parallel with a serial circuit including the valve AV5 and the controller MFC2.

These valves are likewise electromagnetic on-off valves which open when energized, and close when deenergized. The massflow controller MFC2 can pass the gas at the predetermined flow rate set therein. The nozzle N3 is arranged at the top wall 10' of the deposition chamber 10, and opens into the deposition chamber.

The deposition chamber 10 is connected to the exhaust device EX and the optical emission spectroscopic analyzer SM for plasma, and is also connected to a pressure sensor PS sensing the pressure in the deposition chamber.

The object holder 3 can be vertically moved by an elevator mechanism EL. The elevator mechanism EL can move the object holder 3 between a raised position shown in Fig. 3 for transferring the substrate S to or from the holder 3 in the deposition chamber 10 by a robot (not shown) and a lowered position shown in Fig. 4 for the film deposition. The substrate S transferred onto the object holder 3 from the outside of the deposition chamber can move in accordance with the vertical movement of the object holder 3 between the position for the film deposition and the position for taking carrying in/out the substrate. As can be seen from the above, the object holder 3 serves also as the object transferring member in the deposition chamber 10.

The holder elevator mechanism EL includes a support member 41 protruding downward from the holder 3 and extending through the lower wall of the deposition chamber for vertical movement, a bellows support plate 6 arranged at the lower end portion of the support member 41, an extensible bellows BL arranged between the lower wall of the deposition chamber 10 and the bellows support plate 6, and an electric servo-motor 7 with a brake for vertically driving one side end portion of the bellows support plate 6 via a ball screw mechanism. The brake of the motor applies a braking force when it is powered off.

The support member 41 in this example is a rod-like member. The motor 7 is attached to a frame 20 extending from the lower wall of the deposition chamber 10.

The bellows BL has the upper and lower ends which are airtightly connected to the lower wall of the deposition chamber and the bellows support plate 6, respectively, and has a cylindrical form airtightly surrounding the portion of the support member 41 outside the deposition chamber 10.

The ball screw mechanism is formed of a screw rod 71 rotated by the servo-motor 7, a nut unit (female screw unit) 81 engaged with the screw rod 71 and supported by the bellows support plate 6 and a bearing 82 rotatably supporting the upper end of the screw rod 71, and the bearing 82 is supported by a frame 20 via an arm member. These motor 7, ball screw mechanism and others form an example of a drive unit vertically driving the support member 41 and the object holder 3 via the bellows support plate 6.

On the other side end portion of the bellows support plate 6, there are arranged guide wheels 61 rolling on guide rails 62 arranged on the frame 20.

According to the holder elevator mechanism EL, when the motor 7 rotates positively, and it positively drives the screw 71 so that the bellows support plate 6, the rod-like support member 41 extending upward therefrom and the holder 3 supported by the support member 41 can be set at the raised position shown in Fig. 3.

Then, the motor 7 rotates reversely to drive the screw rod 71 reversely so that the bellows support plate 6, the rod-like support member 41 extending upward therefrom and the holder 3 supported by the support member 41 can be set at the lowered position shown in Fig. 4.

A counter balance mechanism CB is also arranged for the holder 3.

The counter balance mechanism CB includes a piston cylinder device 5 and a working fluid circuit 9 for it. The piston cylinder device 5 in this embodiment is a pneumatic device, and the circuit 9 is a compressed air circuit. The piston cylinder device 5 and the circuit 9 may employ a fluid other than the air.

The piston cylinder device 5 is of a double-acting type, and its piston rod 52 is connected to a screw 411 of the lower end of the support member 41 supporting the holder 3 via a screw joint 520, and thereby is connected to the holder 3.

The compressed air circuit 9 includes an electromagnetic on-off valve 911 of a 3-port and 2-position double solenoid type, a lubricator (oiler) 912 and a pressure regulating valve 913 which are successively connected via piping to a cylinder tube port on the rod cover side of the piston cylinder device 5.

Further, the compressed air circuit 9 includes an electromagnetic on-off valve 921 of a 3-port and 2-position double solenoid type, a lubricator 922 and a pressure regulating valve 923 which are successively connected via piping to a cylinder tube port on the head cover side of the piston cylinder device 5.

The pressure regulating valves 913 and 923 are connected via piping to a compressed air source 90 such as a compressor via a filter 901. Silencers 914 and 924 are provided for valves 911 and 921, respectively.

When the solenoid SOL11 of the electromagnetic valve 911 is deenergized and the solenoid SOL12 is energized, the valve 911 does not allow the supply of the compressed air to the piston cylinder device 5 as shown in Fig. 3.

However, by keeping the solenoids SOL11 and SOL12 in the on and off states, respectively, the valve position is switched to supply the compressed air to the tube port on the rod side of the piston cylinder device 5 as shown in Fig. 4.

In the above state, the compressed air pressure supplied to the rod-side port of the cylinder tube is a pressure regulated by the pressure regulating valve 913, and applies the following opposite force to the piston 51. By setting of the depressurized atmosphere for film deposition in the deposition chamber 10, a force f is caused by a difference between inner and outer pressures of the deposition chamber 10, and is applied to a portion of the bellows support plate 6 corresponding to a diameter (sectional area) of the bellows BL. There is a force F (= f - WF) acting to contract the bellows BL, and this force F is determined by subtracting a member gravity·WF of the object holder 3, support member 41, bellows support plate 6, objects on the holder 3 and others from the above force f. The piston 51 receives the opposite force to cancel the above force F (= f - WF) and, in other words, to cancel the load applied to the drive unit (motor 7 and the like) based on the force F. When the solenoid SOL11 is energized, the solenoid SOL21 of the electromagnetic on-off valve 921 is deenergized, and the solenoid SOL22 is energized so that the air on the head cover side in the cylinder tune is discharged to an ambient space via the valve 921 and silencer 924.

When the solenoid SOL21 of the electromagnetic valve 921 is deenergized and the solenoid SOL22 is energized, the valve 921 does not allow the supply of the compressed air to the piston cylinder device 5 as shown in Fig. 4.

However, by keeping the solenoids SOL21 and SOL22 in the energized and deenergized states, respectively, the valve position is switched to supply the compressed air to the tube port on the head cover side of the piston cylinder device 5 as shown in Fig. 3.

The pressure of the compressed air thus supplied to the head-side port of the cylinder tube is a pressure regulated by the pressure regulating valve 923 and applies such a opposite force to the piston 51 when the atmospheric pressure is kept in the deposition chamber 10 that cancels the member gravity WF of the object holder 3, support member 41, bellows support plate 6 and others and, in other words, cancels the load applied to the drive unit (motor 7 and others) based on the force WF. When the solenoid SOL21 is energized, the solenoids SOL11 and SOL12 of the electromagnetic valve 911 are in the deenergized and energized states, respectively, and the air on the rod-cover side in the cylinder tube is discharged into the ambient space via the valve 911 and silencer 914.

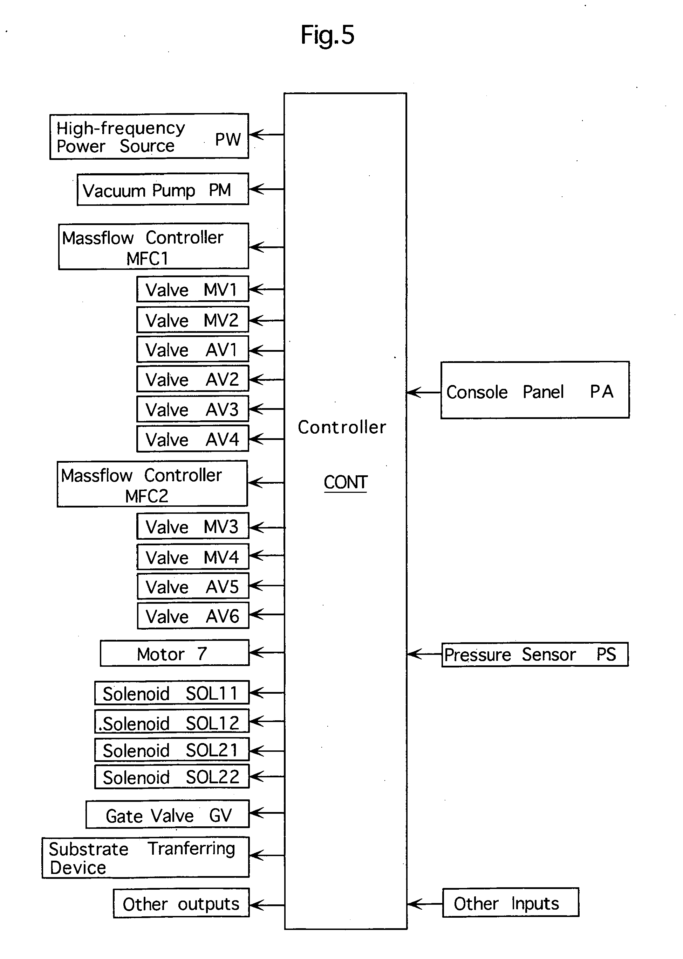

Fig. 5 is a block diagram schematically showing a control circuit of the film forming apparatus B.

This control circuit includes a control unit CONT including a microcomputer and others. The control unit CONT provides instructions for controlling the high-frequency power source PW, the vacuum pump PM, the massflow controller and various electromagnetic on-off valves in the gas supply device 100, the motor 7 of the holder elevating mechanism, the solenoids SOL11 - SOL22 of the electromagnetic on-off valves in the compressed air circuit 9, a gate valve GV, a substrate transferring device (not shown in Figs. 3 and 4) for taking in and out the substrate S and others.

The control unit CONT is configured to receive deposition chamber pressure information from the pressure sensor PS, and is also connected to a console panel PA for instructing operations such as start of the film formation and others.

According to the film forming apparatus B, the silicon film can be formed on the substrate S, e.g., in such a manner that the chemical sputtering of the target 2 and the supply of the monosilane gas are performed simultaneously, or that the chemical sputtering of the target 2 starts prior to the start of the supply of the monosilane gas and the monosilane gas is supplied after the start of the sputtering. In the former manner, the silane gas supply is performed using the gas reservoir unit GR or without using it. In the latter manner, the silane gas supply is likewise performed using the gas reservoir unit GR or without using it.

### (2-1) Film formation simultaneously performing the chemical sputtering of the target and the supply of the monosilane gas

### (2-1-1) In the case of using the gas reservoir unit GR

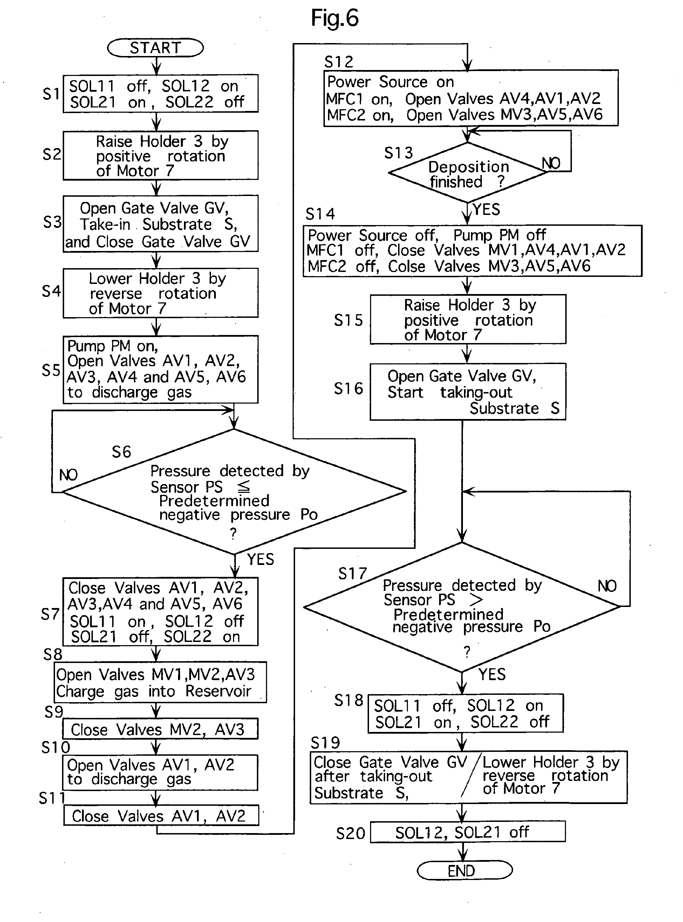

The film formation in this case will now be described with reference to a flowchart of Fig. 6 illustrating an operation of the control unit CONT in this case.

Initially, the power source PW, the pump PM, the massflow controller and various electromagnetic on-off valves in the gas supply device 100, the motor 7 and the solenoids SOL11 - SOL22 of the electromagnetic on-off valves in the compressed air circuit 9 are all off, the gate valve GV is closed and the deposition chamber 10 is kept at the atmospheric pressure.

When the instruction for film formation is entered via the console panel, the pressure sensor PS is in such a state that the pressure information provided from the sensor PS to the control unit CONT is indicating the atmospheric pressure, and the solenoid SOL11 of the on-off valve 911 in the compressed air circuit 9 are turned off. Also, the solenoid SOL12 thereof is turned on, the solenoid SOL21 of the valve 921 is turned on and the solenoid SOL22 thereof is turned off (step S1 in Fig. 6).

Thereby, the port on the head cover side of the piston cylinder device 5 is supplied with the compressed air generating the opposite force that can cancel the member gravity WF of the object holder 3 and others, and the motor 7 rotates positively to raise the holder 3 while canceling the load caused by the member gravity WF on the motor 7 so that the holder 3 is located at the raised position opposed to the gate valve GV (S2 in Fig. 6).

Then, the gate valve GV opens, the deposition target substrate S is placed on the object holder 3 and the valve GV is closed again (S3 in Fig. 6). Then, the motor 7 reversely rotates to lower the object holder 3, and the substrate S held thereon is located in the deposition position (S4 in Fig. 6). While the object holder 3 is lowering, the piston cylinder device 5 cancels the load which may be applied to the motor 7 due to the member gravity WF.

In the state where the atmospheric pressure is kept in the deposition chamber 10, the vertical movement of the object holder 3 is performed while generating the opposite force canceling the member gravity WF to cancel the load on the drive unit and particularly the motor 7. Therefore, the vertical movement of the object holder 3 can be performed even by the motor 7 having a small torque, and also the ball screw mechanism can have a simple structure owing to the small required torque of the motor. Therefore, the drive unit formed of the motor 7 and the like can have a small capacitance and thus can be inexpensive so that the film forming apparatus can be inexpensive.

Since the vertical movement of the object holder 3 is performed while canceling the load applied to the drive unit, the holder 3 can readily move and can readily stop according to the stop of the motor. Further, a shock caused at the time of stopping can be small so that the holder 3 can accurately stop at the predetermined lowered position. Also it is possible to suppress deviation in position and damages of the substrate S.

At the time of a power failure, the electromagnetic on-off valves 911 and 921 in the compressed air circuit 9 are kept at the same positions as those attained before the power failure so that falling of the object holder 3 can be prevented, and the position shift and/or damages of the substrate S held on the holder 3 can be prevented.

When the substrate S is located at the film deposition position as described above, the pump PM is turned on to start exhausting from the deposition chamber 10. Also, the valves AV1, AV2, AV3 and AV4 in the gas supply device 100 are turned on to discharge the gas while still keeping the massflow controller MFC1 in the silane gas supply circuit 101 off. Further, the valves AV5 and AV6 in the hydrogen gas supply circuit 102 are turned on to discharge the gas while still keeping the massflow controller MFC2 off (S5 in Fig. 6). The valve MV4 can be used for discharging the gas during maintenance.

Thereafter, valves AV1, AV2, AV3, AV4, AV5 and AV6 are turned off and closed after the pressure information provided from the pressure sensor PS indicates a pressure not exceeding the predetermined negative pressure Po which is lower than the atmospheric pressure but is higher than the deposition pressure (S6 in Fig. 6). For vertically driving the object holder 3 when the depressurized state for the film deposition is set in the deposition chamber 10, the solenoid SOL11 of the electromagnetic on-off valve 911 in the compressed air circuit 9 is turned on, the solenoid SOL12 is turned off, the solenoid SOL21 of the valve 921 is turned off and the solenoid SOL22 is turned on (S7 in Fig. 6).

Thereby, the operation starts to supply the compressed air, which can generate the opposite force canceling the force F (= f - WF) acting to contract the bellows BL, to the port on the rod cover side of the piston cylinder device 5. In this manner, it becomes possible to move vertically the holder 3 by driving the motor 7 while canceling the load based on the force F and exerted on the motor 7.

Then, the valves MV1, MV2 and AV3 in the silane gas supply circuit 101 are turned on and opened to fill the gas reservoir unit GR with the silane gas, and thereafter the valves MV2 and AV3 are closed (S8 and S8 in Fig. 6). Subsequently, the valves AV1 and AV2 are opened to discharge the gas, and then are closed again (S10 and S11 in Fig. 6).

Then, the high-frequency power source PW is turned on to start the application of the high-frequency power to the high-frequency antenna 1, and the valve AV4 in the silane gas supply circuit 101 is opened to supply suddenly, i.e., in a pulse-like fashion the silane gas kept in the gas reservoir unit GR into the deposition chamber 10. At the same time, the massflow controller MFC1 is turned on and the valves AV1 and AV2 are opened to supply the silane gas into the deposition chamber 10 at the flow rate controlled by the controller MFC1. Further, at the same time, the massflow controller MFC2 in the hydrogen gas supply circuit 102 is turned on and the valves MV3, AV5 and AV6 are opened to start supplying the hydrogen gas into the deposition chamber 10 at the flow rate controlled by the controller MFC2 (S12 in Fig. 6).

The gas thus supplied into the deposition chamber is changed into the plasma by applying the high-frequency power thereto, and the chemical sputtering is effected on the silicon sputter target 2 in the plasma thus produced so that the silicon film is deposited on the substrate S, and also the silicon film is formed on the substrate S in the plasma of the monosilane gas and the hydrogen gas. Thereby, the deposition rate or speed of the silicon film can be high.

In this film deposition, the chemical sputtering of the silicon sputter target 2 forms nucleuses or seeds promoting the growth of the silicon film on the substrate S so that the film deposition can be started more smoothly. Further, the monosilane gas (SiH₄) is stored in the gas reservoir unit GR prior to the supply, and will be supplied suddenly (i.e., in the pulse-like fashion) therefrom into the deposition chamber 10 at the start of the film formation. Therefore, when the film deposition starts, the silane gas suddenly supplied from the gas reservoir unit GR suddenly spreads over the deposition chamber 10 so that the silane gas plasma density of a predetermined value or a value close to it can be achieved in the deposition chamber even at the start of the film formation.

Simultaneously with the supply of the silane gas from the gas reservoir unit GR, the operation starts to supply the silane gas and the hydrogen gas into the deposition chamber 10 at the flow rates controlled by the massflow controller MFC1 and MFC2, respectively. Then, the silane gas and the hydrogen gas are continuously supplied into the deposition chamber 10 at the controlled flow rates so that the plasma density at the start of the film formation reliably attains the predetermined value or the value close to it, and the predetermined plasma density will be kept thereafter.

Owing to the above operations, the film deposition on the substrate S starts smoothly, and thereby good quality can be achieved in the film including the portion that will be formed later so that the entire film of good quality can be formed fast.

After the film deposition for a predetermined time, i.e., after the film of a predetermined thickness is formed (S13 in Fig. 6), the power source PW, the pump PM and the massflow controllers MFC1 and MFC2 are turned off, the valves MV1, MV3, AV1, AV2, AV4, AV5 and AV6 are closed (S14 in Fig. 6), the motor 7 rotates positively to raise the holder 3 (S15 in Fig. 6) and the gate valve GV opens to start the operation of taking out the substrate S having the deposited film.

When the object holder 3 is to be raised and the reduced pressure is still kept in the deposition chamber 10, the foregoing force F (= f - WF) contracting the bellows BL is acting, but the compressed air generating the opposite force canceling the force F is supplied to the port on the rod cover side of the piston cylinder device 5 so that the load based on the force F and exerted on the motor 7 is cancelled.

Therefore, even when the torque of the motor 7 is small, it can raise the object holder 3 readily. Also, the holder 3 can be stopped readily without causing a large shock in response to the stop of the motor. Thereby, the holder 3 can be accurately stopped at the predetermined raised position without a large shock, and the position shift and the damage of the substrate S having the deposited film can be suppressed.

Further, at the time of a power failure, the electromagnetic on-off values 911 and 921 in the compressed air circuit 9 are maintained at the same positions as those attained immediately before the power failure so that the jumping of the object holder 3 can be prevented, and the position shift and the damage of the substrate S having the deposited film can be suppressed.

Even when the object holder 3 is to be lowered for a certain reason while the force F is acting, the object holder 3 can be lowered smoothly, and can be accurately stopped at the desired position without a large shock.

When the gate valve GV is opened for taking out the substrate S having the deposited film, and thereby the pressure information provided from the pressure sensor PS indicates the pressure larger than the predetermined negative pressure Po already described (S17 in Fig. 6), the solenoids SOL11 and SOL12 of the electromagnetic selector valve 911 in the compressed air circuit 9 are turned off and on, respectively, and the solenoids SOL21 and SOL22 of the valve 921 are turned on and off, respectively, (step S18 in Fig. 6) so that the piston cylinder device 5 generates the opposite force canceling the member gravity WF.

After the substrate is taken out, the motor 7 rotates reversely to lower the holder 3, and the gate valve GV is closed (S19 in Fig. 6). Further, the solenoids SOL12 and SOL21 of the electromagnetic on-off valves in the compressed air circuit 9 are turned off (S20 in Fig. 6).

When the film deposition is to be performed subsequently, a new substrate S can be placed on the empty object holder 3 for continuing the film deposition after taking out the substrate having the film thus deposited.

For example, the following structure and manner may be employed. A load/unload lock chamber LR is arranged for the deposition chamber 10 with the gate valve GV interposed therebetween. When the substrate S is to be transferred onto the holder 3, the gate valve GV is closed to keep the predetermined deposition pressure in the chamber 10, and the chamber LR is opened to accept the substrate S by a robot arranged therein from the outside. Then, the chamber LR is closed, and the gas is discharged to attain the inner deposition chamber pressure. Thereafter, the gate valve GV is opened to transfer the substrate S from the robot to the holder 3. For taking out the substrate having the deposited film, the chamber LR is kept at the deposition chamber pressure, the valve GV is opened and the substrate having the deposited film is transferred from the holder 3 into the chamber LR. Then, the valve GV is closed, and the chamber LR opens for taking out the substrate having the deposited substrate from the chamber LR. In this case, the deposition chamber 10 is kept at the atmospheric pressure in some steps so that it is desired to arrange the counter balance mechanism.

An example of an experiment of forming a silicon film by the film forming apparatus B will now be described.

### <Experimental Example>

The deposition conditions are as follows:
High-frequency power: 60 MHz, 4000 W
Pressure and quantity of silane gas (SiH₄) stored in gas reservoir unit GR
   Pressure: 0.07 MPa
   Quantity: 231 cc (selectable between 100 cc - 300 cc)
Quantity of silane gas supplied by massflow controller MFC1:
   1 sccm
Quantity of hydrogen gas supplied by massflow controller MFC2:
   150 sccm
Deposition pressure: 0.67 Pa (5 mTorr)
Deposition chamber capacity: 1.5 m³
Deposition target substrate: non-alkali glass substrate
Substrate temperature: 400 deg. C. (400°C)
Deposition film thickness: 500 angstroms (500Å)

The silicon film was formed on the substrate under the above conditions, and a UV (ultraviolet ray) reflection side intensity in the interface between the film and the substrate and a UV reflection side intensity on the film surface were measured by the UV reflectance measurement. According to the result, the silicon film exhibited the high UV reflection side intensity on both the interface side and the front surface side of the film, and was confirmed as the crystalline silicon film of good quality. The UV reflection side intensity is a result of the UV reflectance measurement with Hitachi UV-3500 Spectrophotometer of HITACHI Ltd. The high reflectance (UV reflection side intensity) represents that there are many free electrons, and thus represents that the crystallization is achieved.

Further, Raman spectral analysis was performed. According to the result, a sharp peak was found at 520 cm⁻¹ exhibiting the crystalline silicon, and the high crystallinity was confirmed.

### (2-1-2) In the case where the gas reservoir unit GR is not used

In this film deposition, the hydrogen gas and the monosilane gas are supplied into the deposition chamber 10 at the flow rates respectively controlled by the massflow controllers MFC1 and MFC2 even at the start of the film formation, and the high-frequency power is applied to these gases to produce the plasma so that the silicon film is formed on the substrate S in the plasma thus formed.

For this film formation, the silane gas supply is performed without using the gas reservoir unit GR, but the chemical sputtering of the silicon sputter target 2 produces the nucleuses or seeds promoting the growth of the silicon film on the substrate S so that the film deposition can be started smoothly. Further, the silane gas and the hydrogen gas are supplied into the deposition chamber 10 at the flow rates respectively controlled by the massflow controllers MFC1 and MFC2 at the start of the film formation, and subsequently will be supplied into the deposition chamber 10 at the controlled flow rates. Therefore, the film deposition on the substrate S can start smoothly, and the whole film including the film portion that will be formed later can be formed fast.

In this film formation, the control unit CONT is configured to control the operations of the gas supply device 100 and others for forming the film in the above manner.

The gas reservoir unit GR may be eliminated when the film deposition is performed in the above manner. The counter balance mechanism CB may be employed, in which case it can function effectively similarly to the foregoing case.

### (2-2) Film deposition performed by starting the chemical sputtering of the silicon sputter target 2 prior to the supply of the silane gas

### (2-2-1) In the case of using the gas reservoir unit GR

For this film deposition, only the hydrogen gas is first supplied from the hydrogen gas supply circuit 102 into the deposition chamber 10, and the high-frequency power is applied thereto to form the hydrogen gas plasma. By the plasma thus formed, the chemical sputtering is effected on the target 2 to start the formation of the silicon film on the substrate S. In this operation, the nucleuses or seeds promoting the growth of the silicon film are formed on the substrate S.

Thereafter, the silane gas supply circuit 101 supplies the monosilane gas into the deposition chamber 10. Prior to the supply, the monosilane gas (SiH₄) is stored in the gas reservoir unit GR, and will be supplied suddenly, i.e., in a pulse-like fashion into the deposition chamber 10 at the start of the supply. Accordingly, the silane gas suddenly supplied from the gas reservoir unit GR can suddenly and fully spread into the deposition chamber 10 so that the silane gas plasma density of the predetermined value or the value close to it can be achieved in the deposition chamber at the start of supply of the silane gas. Further, the silane gas is supplied into the deposition chamber 10 at the flow rate controlled by the massflow controller MFC1 at the same time as the silane gas supply from the gas reservoir unit GR, and thereafter it will be supplied at the controlled flow rate. Thereby, the film deposition on the substrate S can start smoothly, and it is possible to deposit fast the whole film including the film portion that will be formed later.

In this film formation, the control unit CONT is configured to control the operations of the gas supply device 100 and others for forming the film in the above manner.

For the above film formation, the counter balance mechanism CB may be employed, in which case it can function effectively, similarly to the foregoing case.

### (2-2-2) In the case where the gas reservoir unit GR is not used

In this film deposition, only the hydrogen gas is first supplied from the hydrogen gas supply circuit 102 into the deposition chamber 10, and the high-frequency power is applied thereto to form the hydrogen gas plasma. By the plasma thus formed, the chemical sputtering is effected on the silicon sputter target 2 to start the formation of the silicon film on the substrate S. Thereafter, the monosilane gas is supplied into the deposition chamber to form the silicon film on the substrate S.

For this film formation, the silane gas is supplied without using the gas reservoir unit GR, but the chemical sputtering of the silicon sputter target 2 produces the nucleuses or seeds promoting the growth of the silicon film on the substrate S so that the film deposition can be started smoothly. Thereafter, the silane gas and the hydrogen gas are supplied into the deposition chamber 10 at the flow rates respectively controlled by the massflow controllers MFC1 and MFC2, and subsequently will be supplied into the deposition chamber 10 at the controlled flow rates. Therefore, the film deposition on the substrate S can start smoothly, and the whole film including the film portion that will be formed later can be formed fast.

In this film formation, the control unit CONT is configured to control the operations of the gas supply device 100 and others for forming the film in the above manner.

The gas reservoir unit GR may be eliminated when the film deposition is performed in the above manner. The counter balance mechanism CB may be employed, in which case it can function effectively similarly to the foregoing case.

### (3) Another example of high-frequency antenna

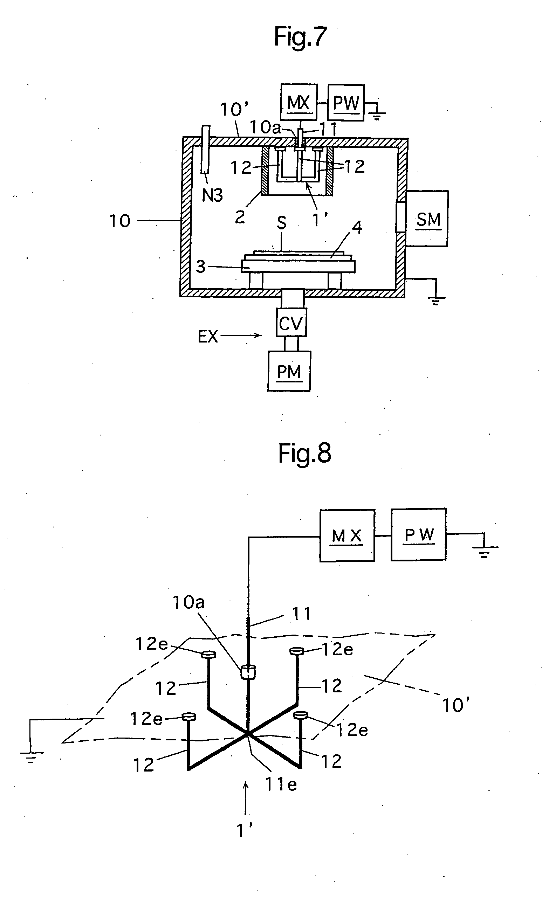

Figs. 7 and 8 shows another example 1' of the high-frequency antenna together with a part of the film forming apparatus A shown in Fig. 1. The high-frequency antenna 1' has a three-dimensional structure, and is formed of a first portion 11 and a plurality of second portions 12. The first portion 11 extends in a straight rod-like form from the outside of the film deposition chamber 10 through its top wall 10' into the chamber 10. The second portion 12 diverges and extends radially from an inner end 11e of the first portion 11 located in the chamber 10 toward the top wall 10'. A termination 12e of each second portion 12 is directly connected to the top wall 10' by a connector, and therefore is grounded via the chamber 10.

As a whole, the group of second portions 12 has such a form that two antenna portions each having a substantially U-shaped form are combined together to exhibit a crossing form in a plan view, and is coupled to the first portion 11.

A surface of a conductive portion of the high-frequency antenna 1' is coated with an insulating film (alumina film in this embodiment).

The first portion 11 of the high-frequency antenna 1' is connected to the high-frequency power source PW via the matching box MX. The first portion 11 has a portion which is located outside the chamber 10 without contributing to plasma production. This portion is extremely short, and is directly connected to the matching box MX. The first portion 11 extends through an insulating member 10a which is arranged at the top wall 10' of the chamber 10, and serves also as gas-tight sealing.

As described above, the high-frequency antenna 1' has a short size, and has a parallel wiring structure diverging in an electrically parallel fashion in the chamber 10. Owing to these structures, the inductance of the antenna 1' is reduced.

The high-frequency antenna 1' can likewise produce the inductively coupled plasma by applying the high-frequency power therefrom to the gas supplied into the deposition chamber 10.

In the above processing, since the high-frequency antenna 1' is the low inductance antenna, the desired plasma can be generated while suppressing disadvantages such as abnormal discharge, matching failure and others. Even in the case where the frequency of the high-frequency power is raised, e.g., to a range of 40 MHz to 100 MHz or several hundreds of megaheltz for improving the plasma characteristics, the desired plasma can be generated while suppressing disadvantages such as abnormal discharge, matching failure and others.

Since the high-frequency antenna 1' has the three-dimensional structure, it can efficiently apply the electric field over a wide range in the chamber 10 even when the antenna 1' is located near the chamber wall. This improves the efficiency of utilizing the high-frequency power.

Since the surface of the conductive portion of the high-frequency antenna 1' is coated with the insulating material, it is possible to suppress disadvantages such as etching with the plasma due to the self-bias.

### INDUSTRIAL APPLICABILITY

The invention can be utilized in the cases of forming the silicon thin films for forming various semiconductor parts, semiconductor devices and others such as TFT (thin film transistor) switches that utilize the silicon films.

## Claims

1. A silicon film forming apparatus comprising:
a deposition chamber accommodating a deposition target object;
a silicon sputter target arranged in the deposition chamber;
a gas supply device having a hydrogen gas supply circuit supplying a hydrogen gas into the deposition chamber; and
a high-frequency power applying device applying a high-frequency power to the hydrogen gas supplied from the hydrogen gas supply circuit into the deposition chamber, and thereby generating inductively coupled plasma, wherein
a silicon film is formed on the deposition target object arranged in the deposition chamber by effecting chemical sputtering on said silicon sputter target by the plasma.

2. The silicon film forming apparatus according to claim 1, wherein
said high-frequency power applying device generates said inductively coupled plasma by discharging from a high-frequency antenna arranged in said deposition chamber.

3. The silicon film forming apparatus according to claim 2, wherein
said silicon sputter target is opposed to at least the high-frequency antenna.

4. The silicon film forming apparatus according to claim 2 or 3, wherein
said high-frequency antenna extends from the outside of said deposition chamber into the deposition chamber, and has a portion located in the deposition chamber and divided electrically in parallel, each of said divided portions has an end directly connected to the deposition chamber, and the deposition chamber potential is set to ground potential.

5. The silicon film forming apparatus according to claim 4, wherein
said high-frequency antenna has a first portion extending from the outside of said deposition chamber through a wall of the deposition chamber into the deposition chamber, and a plurality of second portions diverging radially from an end of the first portion inside the deposition chamber, and extending toward said deposition chamber wall, and the end of each of the second portions is directly connected to the deposition chamber wall.

6. The silicon film forming apparatus according to claim 4 or 5, wherein
at least a portion of said high-frequency antenna located in said deposition chamber is coated with an electrically insulating material.

7. The silicon film forming apparatus according to any one of the preceding claims 1 to 6, wherein
said gas supply device includes a silane gas supply circuit supplying a silane gas into the deposition chamber simultaneously with the supply of the hydrogen gas from the hydrogen gas supply circuit into the deposition chamber.

8. The silicon film forming apparatus according to any one of the preceding claims 1 to 6, wherein
said gas supply device includes a silane gas supply circuit supplying a silane gas into said deposition chamber after the start of the chemical sputtering of said silicon sputter target by the hydrogen gas plasma.

9. The silicon film forming apparatus according to claim 7 or 8, wherein
said silane gas supply circuit includes:
a gas reservoir unit storing the silane gas prior to the start of the silane gas supply, and then suddenly supplying the stored silane gas into said deposition chamber in the operation of supplying the silane gas into said deposition chamber, and
a silane gas supply unit including a flow rate control unit starting the supply of the silane gas into said deposition chamber at a controlled flow rate simultaneously with the supply of the silane gas from the gas reservoir unit, and thereafter continuing the supply of the silane gas into said deposition chamber at a controlled flow rate.

10. The silicon film forming apparatus according to any one of the preceding claims 1 to 9, further comprising:
a transporting member arranged in said deposition chamber for moving said deposition target object between a first position for silicon film formation and a second position different from the first position, an elevator mechanism for vertically moving the transporting member, and a counter balance mechanism, wherein
said elevator mechanism includes:
a transporting member support member for supporting the transporting member, and vertically movably extending through a wall of said deposition chamber, a bellows supporting member arranged at an end of a portion of the transporting member supporting member located outside said deposition chamber, an extensible bellows having one end air-tightly connected to the deposition chamber and the other end air-tightly connected to the bellows supporting member, and air-tightly surrounding a portion of the transporting member supporting member located outside said deposition chamber, and a drive unit vertically driving the transporting member supporting member; and
said counter balance mechanism is configured at least to generate opposite forces canceling a first load applied to said drive unit when the inner pressure of said deposition chamber is the same as the inner pressure at the time of setting a depressurized atmosphere for the silicon film formation, and a second load applied to said drive unit when the inner pressure of said deposition chamber is a predetermined high pressure higher than the inner pressure at the time of setting the depressurized atmosphere, respectively.

11. The silicon film forming apparatus according to claim 10, wherein
said transporting member also serves as an object holder for holding the deposition target object in the first position.

12. The silicon film forming apparatus according to claim 10 or 11, wherein
the high pressure higher than the inner pressure at the time of setting the depressurized atmosphere is the atmospheric pressure.

13. The silicon film forming apparatus according to claim 10, 11 or 12, wherein
said counter balance mechanism includes a piston cylinder device having a piston rod coupled to said support member of the transporting member, and a working fluid circuit supplying a working fluid to the piston cylinder device to cancel said first load in an operation of canceling the first load, and supplying the working fluid to the piston cylinder device to cancel said second load in an operation of canceling the second load.

14. The silicon film forming apparatus according to claim 13, wherein
said working fluid circuit can maintain said piston cylinder device in a state attained before a power failure during the power failure.

15. The silicon film forming apparatus according to claim 13 or 14, wherein
said piston cylinder device is a pneumatic piston cylinder device, and said working fluid circuit is a compressed air circuit.

16. The silicon film forming apparatus according to any one of the preceding claims 10 to 15, wherein
said drive unit includes a rotary motor, and a transmission mechanism converting a rotational motion of the motor to a linear motion, and transmitting the motion to said support member of the transporting member.

17. The silicon film forming apparatus according to claim 16, wherein
said rotary motor is a servo motor with a brake.

18. The silicon film forming apparatus according to any one of the preceding claims 1 to 17, wherein
said silicon film forming apparatus is a film forming apparatus forming a crystalline silicon film.
